# EUROPEAN PATENT SPECIFICATION

(11) **EP 2 997 595 B1**
(45) Date of publication and mention of the grant of the patent: **18.11.2020**
(21) Application number: 14836801.2
(22) Date of filing: 16.05.2014
(51) Int. Cl.: H01L 23/29, H01L 21/56, H01L 23/552, H01L 23/556, H01L 21/78

(54) **METHOD OF FORMING A RADIATION HARDENED MICROELECTRONIC CHIP PACKAGE**
VERFAHREN ZUR HERSTELLUNG EINES STRAHLUNGSGEHÄRTETEN MIKROELEKTRONISCHEN CHIPGEHÄUSES
PROCÉDÉ DE FORMATION D'UN BOÎTIER DE PUCE MICROÉLECTRONIQUE DURCI PAR RAYONNEMENT

(30) Priority: 16.05.2013 US 201361855488 P
(43) Date of publication of application: 23.03.2016
(73) Proprietor: National Institute Of Aerospace Associates, Hampton VA 23666-6147 (US); U.S.A. As Representated By The Administrator Of The National Aeronautics And Space Administration, Washington, DC 20546 (US)
(72) Inventor: KANG, Jin, Ho, Newport News, VA 23602 (US); SAUTI, Godfrey, Hampton, VA 23666 (US); PARK, Cheol, Yorktown, VA 23693 (US); GIBBONS, Luke, Martinez CA 94553 (US); THIBEAULT, Sheila, A., Hampton, VA 23669 (US); LOWTHER, Sharon, E., Hampton, VA 23666 (US); BRYANT, Robert, G., Williamsburg, VA 23090 (US)
(74) Representative: Akers, Noel James
(86) International application number: PCT/US2014/000125
(87) International publication number: WO 2015/023312

(56) References cited:
- EP-B1- 0 102 525
- WO-A1-2011/139384
- CN-A- 102 127 391
- JP-A- S 628 097
- JP-A- H05 267 504
- JP-A- S59 208 862
- JP-A- 2008 042 152
- JP-A- 2013 088 265
- US-A- 4 468 411
- US-A- 4 960 846
- US-A- 5 998 867
- US-A1- 2010 009 165
- US-A1- 2010 009 165
- US-A1- 2011 068 441
- US-A1- 2012 187 549
- US-A1- 2013 056 641
- US-B1- 6 255 719
- US-B1- 6 261 508
- US-B1- 6 319 740
- MORARI ET AL.: 'Electrical Conductivity And Electromagnetic Shielding Effectiveness Of Silicone Rubber Filled With Ferrite And Graphite Powders.' PROGRESS IN ELECTROMAGNETICS RESEARCH M vol. 21, 30 September 2011, pages 93 - 104, XP055263729 Retrieved from the Internet: <URL:http://www.jpier.org/PIERM/pierm21/07. 11080406.pdf>
- Maddie Stone: "Here Are the True Radiation Dangers in Your Environment", , 17 August 2015 (2015-08-17), XP055674657, Retrieved from the Internet: URL:https://gizmodo.com/here-are-the-true- radiation-dangers-in-your-environment-1723 239205 [retrieved on 2020-03-09]
- Anonymous: "Electromagnetic Spectrum - Wavelength, Frequency, And Energy, Wavelength Regions - Light, Radiation, Visible, and Wavelengths - JRank Articles", , 1 January 2015 (2015-01-01), XP055674654, Retrieved from the Internet: URL:https://science.jrank.org/pages/2368/E lectromagnetic-Spectrum.html [retrieved on 2020-03-09]
- Blackley, D.C.: "Polymer Latices Science and Technology", 31 December 1997 (1997-12-31), Springer Science Business Media, Dordrecht ISBN: 978-94-010-6479-3 vol. 2, pages 499-499,

## Description

### BACKGROUND OF THE INVENTION

### 1. Field of the Invention

The present invention relates to hardened chip package technology and more particularly to hardened chip package technology against high energy radiation.

### 2. Description of Related Art

The reference numbers in brackets below in the specification refer to the appended list of references.

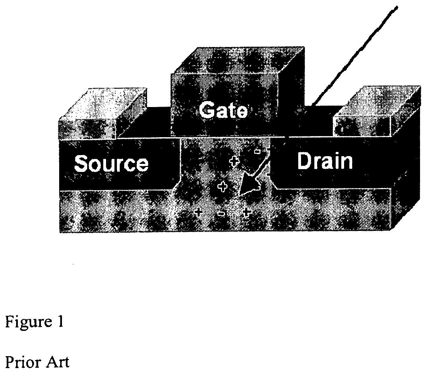

High energy radiation is ubiquitous in the space environment and can cause calculation and memory failures in microelectronic devices (Figure 1) [Ref. 1]. In addition, with the increase in the integration and density of microelectronic circuit chips, the transistors, which are getting much smaller, are more vulnerable to catastrophic failure mechanisms that can be triggered when high energy radiation or high energy particles, such as heavy ions, protons, alpha particles, and neutrons pass through the device structure.

The present invention provides radiation hardened chip packaging technology that protects avionic devices against high energy radiation during space exploration and high altitude flight. There have been several attempts to reduce radiation damage, such as a new logical design to correct the soft error and a physical design to increase gate charge [Refs. 2 and 3]. However, these methods require an additional volume increase of the microelectronic chip and a resulting higher power consumption, which limits the size and capability of the device. Thus, the implementation of specialized microchips used in aerospace has been slow due to the longer times, higher costs, and limited markets required for separate design and manufacturing of the current style of radiation hardened chips. Unfortunately, even these new configurations cannot promise reliable protection against radiation damage. Other methods are utilizing radiation shielding materials as packaging materials [Refs. 4 and 5]. However, these methods cannot protect against various radiation sources. In addition, the complicated process hinders the use of those technologies in semiconductor chip manufacturing without further investment in facilities.

US 6 255 719 discloses a semiconductor device including thermal neutron absorption material.

US 6 261 508 discloses a method for making a shielding composition.

JP H05 267504 discloses a resin composition and a semiconductor device sealed or covered with the resin composition.

It is a primary object of the present invention to provide an efficient shielding packaging composed of a multi-layered structure of rare earth element/polymer composites, which can be applicable to any structure of microelectronic circuit chip to protect from a variety of radiation sources from alpha particles and neutrons to high energy electromagnetic radiation.

It is an object of the invention to provide radiation hardened chip packaging technology which can be applicable to current semiconductor chip packaging processes.

It is an object of the invention to provide sensor and actuator devices fabricated with radiation hardened packaging materials.

It is an object of the invention to provide microprocessor and memory chips fabricated with radiation hardened packaging materials.

It is an object of the invention to provide electronic and optoelectronic parts fabricated with radiation hardened packaging materials.

It is an object of the invention to provide electronic and electrical systems protected by radiation hardened packaging technology.

Finally, it is an object of the present invention to accomplish the foregoing objectives in a simple and cost effective manner.

The above and further objects, details and advantages of the invention will become apparent from the following detailed description, when read in conjunction with the accompanying drawings.

### SUMMARY OF THE INVENTION

The present invention addresses these needs by providing a method for forming a radiation-hardened chip package in accordance with claim 1. If needed, holes are etched in the alpha particle shielding material coating, the high energy particle shielding composite material and the high energy EM wave shielding composite material for the attachment of wiring. The coated circuit chip may be sliced into a plurality of dies, each of which is attached to a pad; and wiring is attached to the coated circuit chip. The alpha particle shielding material is preferably a pristine polyimide and more preferably a siloxane containing polyimide. The high energy particle shielding composite material is a gadolinium/polyimide composite which is 5 wt% Gd. The high energy electromagnetic (EM) wave shielding composite material includes a rare earth element, and more preferably further includes a layered film of composite with conductive particles or composite with carbon nanotubes. Alternatively, the high energy EM wave shielding composite material may be infused with silver.

### BRIEF DESCRIPTION OF THE DRAWINGS

A more complete description of the subject matter of the present invention and the advantages thereof, can be achieved by reference to the following detailed description by which reference is made to the accompanying drawings in which:
Fig. 1 shows radiation damage of a microelectronic chip;
Fig. 2a is a schematic diagram of radiation hardened microelectronic chip packaging;
Fig. 2b is a schematic diagram of radiation hardened microelectronic chip packaging in which layers L2 and L3 are etched to allow wiring to pass through only L1;
Fig. 3a is a diagram of a process of radiation hardened chip package;
Fig. 3b shows the process for wafer level shielding;
Fig. 4 shows the X-ray diffraction pattern of a Gadolinium /polyimide composite; and
Fig. 5 shows the radiation shielding effect of a Gadolinium /polyimide composite.

### Element list

10 Integrated circuit die
12 Alpha particle shielding (LI)
14 High energy particle (p,n, etc.) shielding (L2)
16 High energy EM shielding (L3)
18 Insulating molding compound (L4)
20 Wiring
22 Solder balls
24 A ball grid array chip scale package with radiation hardened technology
26 A ball grid array chip scale package with modified radiation hardened technology to minimize cross talk

### DETAILED DESCRIPTION OF THE PREFERRED EMBODIMENT

The following detailed description is of the best presently contemplated mode of carrying out the invention. This description is not to be taken in a limiting sense, but is made merely for the purpose of illustrating general principles of embodiments of the invention. The embodiments of the invention and the various features and advantageous details thereof are more fully explained with reference to the non-limiting embodiments and examples that are described and/or illustrated in the accompanying drawings and set forth in the following description. It should be noted that the features illustrated in the drawings are not necessarily drawn to scale, and the features of one embodiment may be employed with the other embodiments as the skilled artisan recognizes, even if not explicitly stated herein. Descriptions of well-known components and techniques may be omitted to avoid obscuring the invention. The examples used herein are intended merely to facilitate an understanding of ways in which the invention may be practiced and to further enable those skilled in the art to practice the invention. Accordingly, the examples and embodiments set forth herein should not be construed as limiting the scope of the invention, which is defined by the appended claims. Moreover, it is noted that like reference numerals represent similar parts throughout the several views of the drawings.

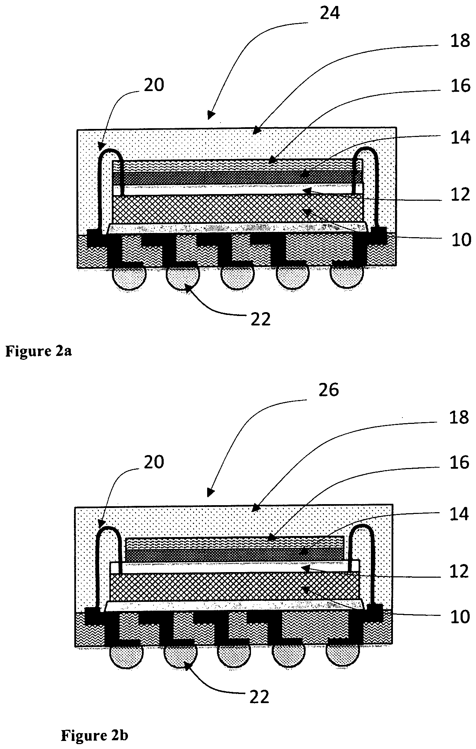

The present technology, as shown in Figure 2a, uses a multilayered structure of rare earth element/polymer composites which is applicable to any structure of microelectronic circuit chip to provide protection from a variety of radiation sources from alpha particles and neutrons to high energy electromagnetic radiation. A ball grid array chip scale package 24 is employed in Figure 2a, but this technology is not limited and may be applied to other packaging technologies such as a quad flat package, a small outline package, a thin small outline package, a flip chip package, a dual in line package, a multichip module package, a flatpack package or a zig-zag in-line package.

The method is to shield the devices, including the circuit chip, using a high performance package insulator. A polyimide coating placed over the chip surface stops alpha particles with energies up to approximately 9 MeV, and rare earth elements, such as Gadolinium and Samarium provide protection against high altitude radiation, Galactic Cosmic Rays (GCRs), and Solar Particle Events (SPEs). The neutron absorption cross sectional area of the rare earth element Gd¹⁵⁷ is 2.59×10⁵ barns, two orders of magnitude higher than that of B¹⁰ (3.84×10³ barns) widely considered as a neutron absorber. In particular, Gd¹⁵⁷ does not produce secondary fission byproducts of alpha particles, which are one of the sources of radiation soft errors in circuits irradiated by neutrons.

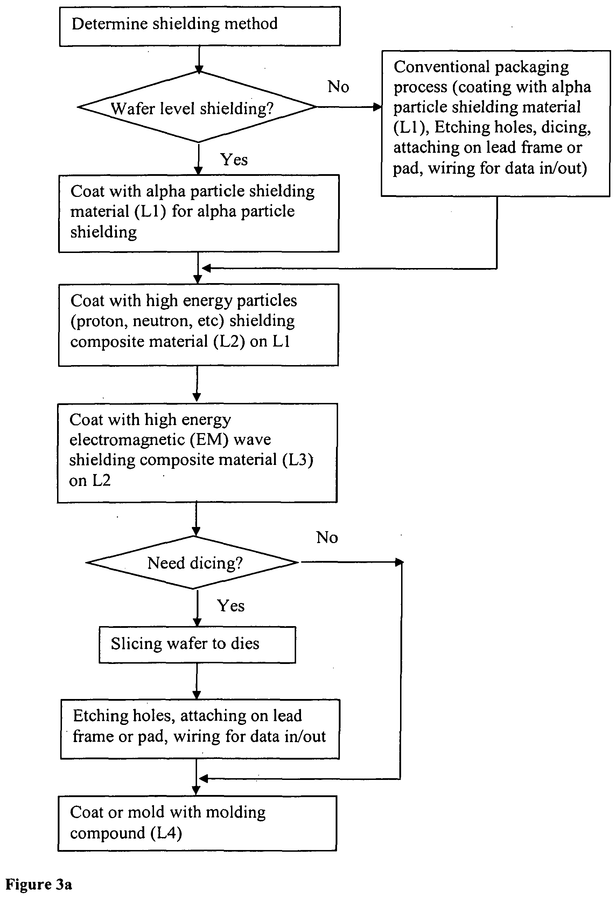

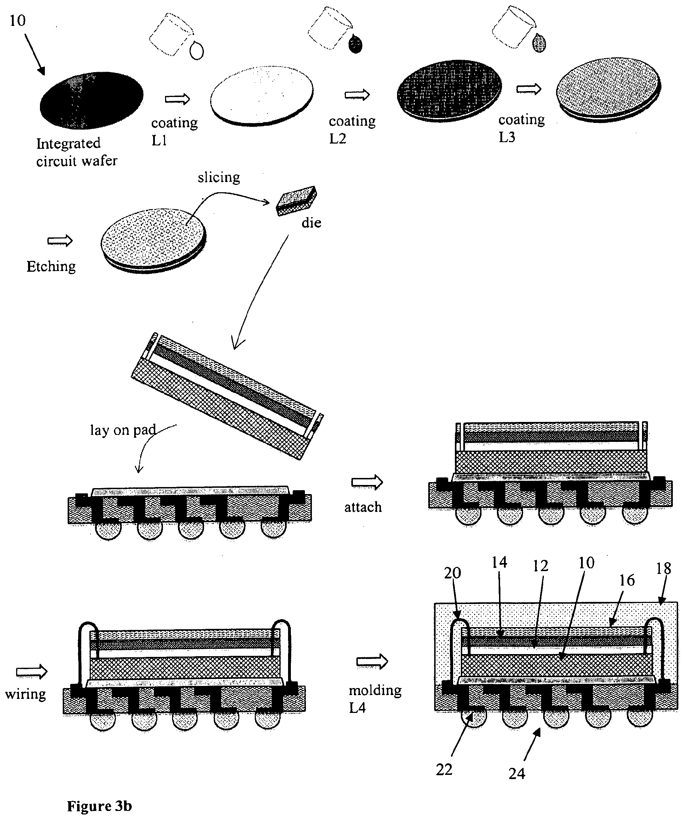

Figure 3a sets forth the process for producing the radiation hardened chip packaging or technology. First, determine the shielding packaging methods of wafer level shielding or die level shielding. Second, an alpha particle shielding layer (L1) 12 is coated on the bare wafer or die 10 (prior art) to protect against alpha particles as shown in Figure 2a. Although any alpha particle shielding material, such as a pristine polyimide other than one containing Gd or CNT, is satisfactory, for better adhesion property, a siloxane containing polyimide is preferred. Third, a high energy particle (proton, neutron, etc) shielding composite material (L2) 14 is coated on L1 12. Fourth, a high energy electromagnetic wave shielding composite material (L3) 16 is coated on L2 14. Fifth, the coated shielding layers are etched to have holes for wiring 20 if needed. The coated L2 14 or L3 16 may be etched or partially coated in order to minimize a cross talk issue between wires 20 as shown in Figure 2b on the ball grid array chip scale package with modified radiation hardened technology to minimize cross talk 26. The wafer is sliced into dies if needed and attached on the lead frame or pad to wiring 20 for data transfer. Last, the die coated with the described multilayer shielding is encapsulated with a proper molding compound, such as an epoxy molding compound, (L4) 18. A conventional molding compound may be used as L4 18, but a radiation hardened resin also may be used as L4 18 for more efficient shielding. Figure 3b shows the process for wafer level shielding.

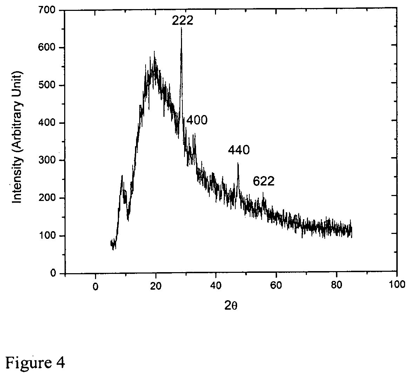

A Gadolinium/polyimide composite is the candidate material for the layer (L2) 14 which shields the chip from high energy particles. Gadolinium/polyimide is preferably prepared by in-situ polymerization. Figure 4 shows the cubic crystalline structure of gadolinium oxide (Gd₂O₃) in polyimide matrix.

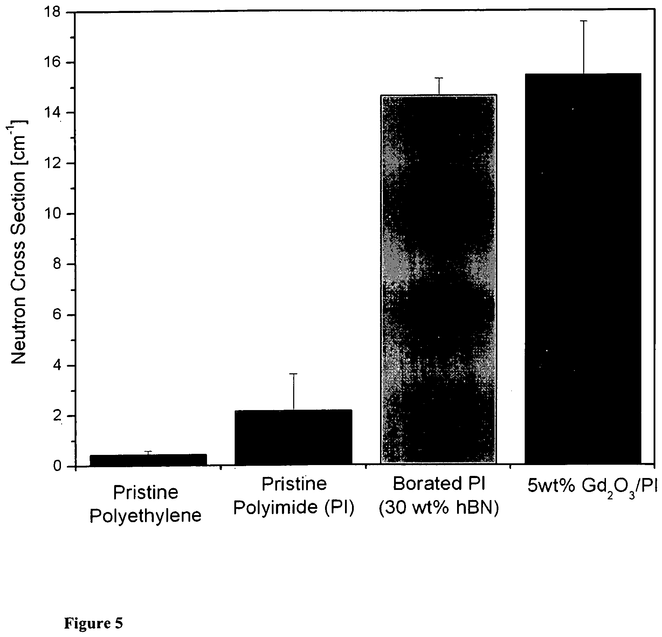

Figure 5 shows the neutron cross sections for pristine polyethylene, pristine polyimide, borated polyimide (30 wt% hBN) and a polyimide composite containing 5 wt% Gd . The cross sections were obtained using a LaRC 1 Ci Americium-Beryllium neutron source (moderated by a polyethylene block). It can be seen from Figure 5 that the Gd/polyimide composite has the largest neutron cross section making it the preferred shielding material. The Gd composite shows a 3240% higher shielding effectiveness as compared to polyethylene, due to Gd's large neutron absorption cross section of about 49700 barns. Moreover the effective shielding is obtained at low Gd loading (5 wt%) ensuring that the material retains its flexibility, processibility and other desirable properties arising from the use of the polyimide matrix. Comparable shielding with hBN requires 30 wt% filler content.

Magnetic properties of rare earth elements efficiently block electromagnetic wave propagation further into the chips. In addition, by layering an additional film of composite with conductive particles or carbon nantoubes, the EMI shielding effect can be enhanced through conductive skin effect. Compared to pristine polyimide, 1% carbon nanotube/polyimide composite film showed about a 400% increase in shielding effectiveness (3dB) at 10 GHz. Additional silver infusion enhanced the shielding effectiveness by about 480% compared to pristine polyimide.

The radiation hardening tests of the memory chip were performed in a radiation facility lab. A memory tester was installed next to the thermal neutron source (A 1 Ci Am/Be source surrounded by a polyethylene block to moderate the neutrons) with a proper shield. Nonvolatile flash memory chips (NAND Flash) with/without radiation hardened composite coatings were attached the holder of the memory tester and characterized in real-time during exposure to neutron irradiation. Without a radiation hardened composite coating, the failure rate was 1.14×10⁻⁷ /bit/hour during 5 days exposure. With Gadolinium/polyimide composite film shielding (about 37 µm thick), the failure rate was 8.49×10⁻¹¹ /bit/hour, which showed 100,000% decrease in failure.

Novel multilayered structures are designed so that each layer can protect against each radiation source like neutrons, protons, alpha particles, and high energy electromagnetic radiation.

The present invention produces knowledge, data, and design tools applicable to all flight regimes, including space missions. Further, the use of radiation hardened packaging materials allows the placement of sensors and/or instruments in harsh environments so that data are obtained for quantification of vehicle performance. Because this technology involves radiation shielding with chip scale packaging of rare earth nanostructured polymer composites, this also contributes to Ionizing Radiation Effects Hazard Management, and the outcome of the developed technology benefits space exploration vehicle systems, such as nuclear powered systems and the High Mass Mars Entry System. Further, this technology protects electronic devices against radiation showers from nuclear accidents or nuclear warfare.

Accordingly, it will be appreciated by those skilled in the art that within the scope of the appended claims, the invention may be practiced other than has been specifically described herein. Many improvements, modifications, and additions will be apparent to the skilled artisan without departing from the scope of the present invention as described herein and defined in the following claims.

### List of References

[Ref. 1] M. O'Bryan et al., IEEE NSREC10 Data workshop, July 2010
[Ref. 2] S. Krishnamohan et al., IEEE International SOC Conference 2004, pp 227-230
[Ref. 3] Q. Zhou et al., IEEE Trans. Comp. Des. Integ. Circ. Sys., 25, 155 (2006).
[Ref. 4] M. Sono, US patent 4,661,837
[Ref. 5] D Czajkowski et al., US patent 5,880,403

## Claims

1. A method for forming a radiation-hardened chip package (24, 26) for a circuit chip (10), comprising:
providing a circuit chip (10);
coating the circuit chip (10) with an alpha particle shielding material (12);
coating the alpha particle shielding material (12) with a high energy particle shielding composite material (14), the high energy particle shielding composite material being a gadolinium/polyimide composite with 5 wt% Gd;
coating the high energy particle shielding composite material (14) with a high energy electromagnetic, EM, wave shielding composite material (16), wherein the high energy EM wave shielding composite material (16) includes a rare earth element, wherein a coated circuit chip (10) is formed; and
encapsulating the coated circuit chip (10), the alpha particle shielding material (12), the high energy particle shielding composite material (14) and the high energy EM wave shielding composite material (16) with a molding compound (18).

2. The method of claim 1 following the coating with a high energy EM wave shielding composite material step, further comprising:
etching holes in the alpha particle shielding material coating (12), the high energy particle shielding composite material (14) and the high energy EM wave shielding composite material (16) for the attachment of wiring (20);
slicing the coated circuit chip (10) into a plurality of dies;
attaching each of the plurality of dies to a pad; and
attaching at least one wire to the circuit chip (10).

3. The method of claim 1 wherein the alpha particle shielding material (12) is a pristine polyimide.

4. The method of claim 1 wherein the alpha particle shielding material (12) is a siloxane containing polyimide.

5. The method of claim 1 wherein the high energy EM wave shielding composite material coating step further comprises layering an additional film of a composite with conductive particles.

6. The method of claim 1 wherein the high energy EM wave shielding composite material coating step further comprises layering an additional film of a composite with carbon nanotubes.

7. The method of claim 1 wherein the high energy EM wave shielding composite material coating step further comprises infusing the high energy EM wave shielding composite material (16) with silver.

8. The method of claim 1 wherein the gadolinium/polyimide composite is prepared by in-situ polymerization.

## Patentansprüche

1. Verfahren zur Bildung eines strahlungsgehärteten Chip-Packages (24, 26) für einen Schaltungschip (10), umfassend:
Bereitstellen eines Schaltungschips (10);
Beschichten des Schaltungschips (10) mit einem Alphapartikel-Abschirmungsmaterial (12);
Beschichten des Alphapartikel-Abschirmungsmaterials (12) mit einem Hochenergiepartikel-Abschirmungsverbundmaterial (14), wobei das Hochenergiepartikel-Abschirmungsverbundmaterial ein Gadolinium/Polyimid-Verbundstoff mit 5 Gew.-% Gd ist;
Beschichten des Hochenergiepartikel-Abschirmungsverbundmaterials (14) mit einem elektromagnetischen, EM, Hochenergiewellen-Abschirmungsverbundmaterial (16), wobei das EM-Hochenergiewellen-Abschirmungsverbundmaterial (16) ein Seltenerdelement beinhaltet, wobei ein beschichteter Schaltungschip (10) gebildet ist; und
Verkapseln des beschichteten Schaltungschips (10), des Alphapartikel-Abschirmungsmaterials (12), des Hochenergiepartikel-Abschirmungsverbundmaterials (14) und des EM-Hochenergiewellen-Abschirmungsverbundmaterials (16) mit einer Gussverbindung (18).

2. Verfahren nach Anspruch 1, nach dem Beschichtungsschritt mit einem EM-Hochenergiewellen-Abschirmungsverbundmaterial weiter umfassend:
Ätzen von Löchern in der Alphapartikel-Abschirmungsmaterialbeschichtung (12), dem Hochenergiepartikel-Abschirmungsverbundmaterial (14) und dem EM-Hochenergiewellen-Abschirmungsverbundmaterial (16) für die Anbringung von Verdrahtung (20);
Schneiden des beschichteten Schaltungschips (10) in eine Vielzahl von Plättchen;
Anbringen jedes der Vielzahl von Plättchen an einem Pad; und
Anbringen mindestens eines Drahts an dem Schaltungschip (10).

3. Verfahren nach Anspruch 1, wobei das Alphapartikel-Abschirmungsmaterial (12) ein makelloses Polyimid ist.

4. Verfahren nach Anspruch 1, wobei das Alphapartikel-Abschirmungsmaterial (12) ein Siloxan-haltiges Polyimid ist.

5. Verfahren nach Anspruch 1, wobei der Beschichtungsschritt mit EM-Hochenergiewellen-Abschirmungsverbundmaterial weiter umfasst, einen zusätzlichen Film aus Verbundstoff mit leitfähigen Partikeln aufzuschichten.

6. Verfahren nach Anspruch 1, wobei der Beschichtungsschritt mit EM-Hochenergiewellen-Abschirmungsverbundmaterial weiter umfasst, einen zusätzlichen Film aus Verbundstoff mit Kohlenstoffnanoröhren aufzuschichten.

7. Verfahren nach Anspruch 1, wobei der Beschichtungsschritt mit EM-Hochenergiewellen-Abschirmungsverbundmaterial weiter umfasst, das EM-Hochenergiewellen-Abschirmungsverbundmaterial (16) mit Silber zu infundieren.

8. Verfahren nach Anspruch 1, wobei der Gadolinium/Polyimid-Verbundstoff durch In-situ-Polymerisation zubereitet ist.

## Revendications

1. Procédé pour former un boîtier de puce durci par rayonnement (24, 26) pour une puce de circuit (10),
comprenant:
une fourniture d'une puce de circuit (10) ;
un recouvrement de la puce de circuit (10) avec un matériau de protection contre des particules alpha (12) ;
un recouvrement du matériau de protection contre des particules alpha (12) avec un matériau composite de protection contre des particules à énergie élevée (14), le matériau composite de protection contre des particules à énergie élevée étant un composite gadolinium/polyimide avec 5 % en poids de Gd ;
un recouvrement du matériau composite de protection contre des particules à énergie élevée (14) avec un matériau composite de protection contre des ondes électromagnétiques, EM, à énergie élevée (16), dans lequel le matériau composite de protection contre des ondes EM à énergie élevée (16) inclut un élément de terres rares, dans lequel une puce de circuit (10) recouverte est formée ; et
une encapsulation de la puce de circuit (10) recouverte, du matériau de protection contre des particules alpha (12), du matériau composite de protection contre des particules à énergie élevée (14) et du matériau composite de protection contre des ondes EM à énergie élevée (16) avec un composé de moulage (18).

2. Procédé selon la revendication 1 suivant le recouvrement avec un matériau composite de protection contre des ondes EM à énergie élevée, comprenant en outre :
une gravure de trous dans le revêtement de matériau de protection contre des particules alpha (12), le matériau composite de protection contre des particules à énergie élevée (14) et le matériau composite de protection contre des ondes EM à énergie élevée (16) pour la fixation d'un câblage (20) ;
un découpage de la puce de circuit (10) revêtue en une pluralité de dés ;
une fixation de chacun de la pluralité de dés sur une pastille ; et
une fixation d'au moins un fil à la puce de circuit (10).

3. Procédé selon la revendication 1 dans lequel le matériau de protection contre des particules alpha (12) est un polyimide vierge.

4. Procédé selon la revendication 1 dans lequel le matériau de protection contre des particules alpha (12) est un polyimide contenant du siloxane.

5. Procédé selon la revendication 1 dans lequel l'étape de recouvrement de matériau composite de protection contre des ondes EM à énergie élevée comprend en outre une stratification d'un film additionnel d'un composite avec des particules conductrices.

6. Procédé selon la revendication 1 dans lequel l'étape de recouvrement du matériau composite de protection contre des ondes EM à énergie élevée comprend en outre une stratification d'un film additionnel d'un composite avec des nanotubes de carbone.

7. Procédé selon la revendication 1 dans lequel l'étape de recouvrement de matériau composite de protection contre des ondes EM à énergie élevée comprend en outre une injection d'argent dans le matériau composite de protection contre des ondes EM à énergie élevée (16).

8. Procédé selon la revendication 1 dans lequel le composite gadolinium/polyimide est préparé par polymérisation in situ.
